# EUROPEAN PATENT APPLICATION

(11) **EP 4 506 758 A1**
(43) Date of publication of application: **12.02.2025**
(21) Application number: 23785024.3
(22) Date of filing: 06.04.2023
(51) Int. Cl.: G03F 7/20

(54) **PARTICLE TRANSFER BLOCKING DEVICE AND LITHOGRAPHY DEVICE WHICH USE ELECTRON LAYER HAVING ELECTROSTATIC TRAP IN VACUUM SYSTEM**

(30) Priority: 06.04.2022 KR 20220042856
(71) Applicant: Derkwoo Semitech Co., Ltd., Seoul 06161 (KR)
(72) Inventor: KIM, Ki Bum, Seoul 06082 (KR)
(74) Representative: Vossius & Partner Patentanwälte Rechtsanwälte mbB
(86) International application number: PCT/KR2023/004668
(87) International publication number: WO 2023/195800

(57) **Abstract**

The present invention relates to a device for preventing fine particles generated in a vacuum system from being adsorbed by a semiconductor substrate and a sample or a mask in a lithography device using the vacuum system, and, more specifically, to an extreme ultraviolet lithography device that does not use a membrane type pellicle. In one embodiment, a particle transfer blocking device according to the present invention comprises: a vacuum chamber in which an accommodation part is formed; a barrier module provided inside the vacuum chamber so as to divide the accommodation part of the vacuum chamber into a first region and a second region; and a particle capture module, which is provided inside the vacuum chamber and captures particles in the chamber, wherein the barrier module is not a physical barrier but an electrical potential barrier for preventing particles located in the first region from transferring to the second region.

## Description

The present disclosure relates to a device for preventing particles generated in a vacuum system from being adsorbed by a semiconductor substrate and a sample or a mask in a lithography device using the vacuum system, and more particularly, an extreme ultraviolet (EUV) lithography device not using a membrane-type pellicle.

During manufacturing processes of semiconductor devices, a process of depositing a thin film on a semiconductor wafer or etching the deposited thin film on the semiconductor wafer by various methods such as physical deposition or chemical deposition may be accompanied. The depositing process or the etching process is typically performed in a vacuum chamber. However, if dusts which have flowed from outside during the depositing process or the etching process or fine particles produced in the vacuum chamber may be adsorbed onto the semiconductor wafer, the manufactured device may be unable to operate appropriately, thereby leading to a degradation of yields of the semiconductor manufacturing processes.

In addition, a patterning process is required to form an integrated circuit using the deposited thin film, and a method called photolithography may be used as a patterning process. During the photolithography, a photomask may be used as a template for the patterning, and at least one pattern on the photomask may be imprinted onto the wafer. However, if the photomask has undesirably adsorbed the dusts or the fine particles, the imprinted pattern may be damaged because light is absorbed therein or reflected thereby due to these elements thereon, thereby decreasing a performance or the yield of the semiconductor device.

Therefore, overall procedures of the semiconductor process integration are typically conducted in a clean room, however, because of the dusts in the clean room and the fine particles produced during the semiconductor process integration, a membrane type pellicle is attached with a specific distance from the photomask in order to prevent the dusts or the fine particles from being adsorbed. In this case, the dusts or the fine particles are not directly adsorbed on a surface of the photomask but on the pellicle membrane. Since a focal point is still matched with the pattern of the photomask during the lithography process even if the dusts are adsorbed on the pellicle, the dusts on the pellicle do not correspond to the focal point and thus are not imprinted to the pattern.

Since the pellicle should have high transmittance for exposure light, the pellicle is configured with a very thin membrane. In particular, as the development of the micropatterning process is in progress, a resolution power of the lithography becomes proportional to a wavelength used for the lithography, and thus an EUV (Extreme UltraViolet) lithography device with a wavelength of 13.5 nm has been developed from a conventional lithography device using ArF wavelength. To achieve continuous scaling-down of the semiconductor pattern, it is expected that the lithography device will use a shorter wavelength gradually. The problem is that because of a high absorbance of the EUV light at the time of penetrating air layer or material, the lithography device must be operated in a vacuum device. In addition, a membrane structure with an extremely thin film of tens of nanometers or less should be used in order to guarantee the transmittance higher than a certain value when manufacturing the pellicle. The thin membrane type pellicle as such has a problem in that the thin film may be damaged or droop because of impacts from outside or stresses at the thin film itself. Further, the pellicle should not be corroded by hydrogen radicals generated during the processes of the lithography and be thermostable to cope with temperature increased by absorbing EUV wavelength. In particular, since the damage or the drooping of the thin film can distort the image during the pattern imprinting process, the mechanical strength of the thin film of the pellicle should be maintained in order to sustain a complete flat state thereof without the drooping or the damage.

For this matter, a method of assigning an adequate tensile stress to the film itself or a method of additionally forming a supporting layer to prevent the thin film of the pellicle from being distorted may be adopted. However, the method not only complicates the pellicle manufacturing process, but also causes problems such as a decrease in the transmittance properties of the thin film of the pellicle due to the addition of the supporting layer, thereby making the development of the pellicle for extreme ultraviolet lithography difficult. Therefore, it is necessary to develop a new type lithography device that prevents the fine particles or the dusts from being adsorbed to the mask even without using the membrane type pellicle.

It is an object of the present disclosure for solving such conventional problems, and it is an object of the present disclosure for providing a device that generates electron beams which are spaced apart by a specific distance from an upper part of a semiconductor substrate placed in a vacuum chamber, and charges particles or dusts generated in the vacuum chamber by electrons in an electron layer, thereby preventing the charged particles or the charged dusts from transferring to the semiconductor substrate with the help of an electrical potential barrier formed by the electron layer. It is another object of the present disclosure to provide a lithography device without using a membrane type pellicle by installing the electrical potential barrier, between a light source for lithography and a mask, which is configured with the electron layer in the vacuum chamber where the light source for lithography is placed.

In order to accomplish objects above, representative structures of the present disclosure are described as follows:
In accordance with one aspect of the present disclosure there is provided a particle transfer blocking device including: a vacuum chamber in which an accommodation part is formed; a barrier module which is provided in the vacuum chamber and divides the accommodation part of the vacuum chamber into a first region and a second region; and a particle capturing module which is provided in the vacuum chamber and captures particles within the vacuum chamber; wherein the barrier module is not a physical barrier but an electrical potential barrier serving to prevent the particles located in the first region from transferring to the second region.

As one example, the particle capturing module is installed in at least one of the first region and the second region, wherein the first region and the second region are adjacent to the barrier module.

As one example, the particle capturing module is an electrostatic trap.

As one example, the barrier module includes: an electron beam generator installed on one side inside the chamber; and an electron beam receptor installed on an opposite side, facing the one side, inside the chamber, wherein the electron beam receptor receives electron beam generated by the electron beam generator.

As one example, the particles are at least one of dusts and fine particles which are produced during processes.

In accordance with another aspect of the present disclosure there is provided a lithography device, including: a vacuum chamber in which an accommodation part is formed; a barrier module which is provided in the vacuum chamber and divides the accommodation part of the vacuum chamber into a first region where a light source for lithography is located and a second region where a substrate is located; and a particle capturing module which is provided in the vacuum chamber and captures particles within the vacuum chamber; wherein the barrier module is not a physical barrier but an electrical potential barrier serving to prevent the particles located in the first region from transferring to the second region.

As one example, the particle capturing module is installed within at least one of the first region and the second region, wherein the first region and the second region are adjacent to the barrier module.

As one example, the particle capturing module is an electrostatic trap.

As one example, the barrier module includes: an electron beam generator installed on one side inside the chamber; and an electron beam receptor installed on an opposite side, facing the one side, inside the chamber, wherein the electron beam receptor receives electron beam generated by the electron beam generator.

As one example, the particles are at least one of dusts and fine particles which are produced during processes.

As one example, the particles are the dusts and Sn particles.

As one example, a mask is formed at the substrate.

As one example, the light source for lithography is an EUV (Extreme Ultraviolet) light source.

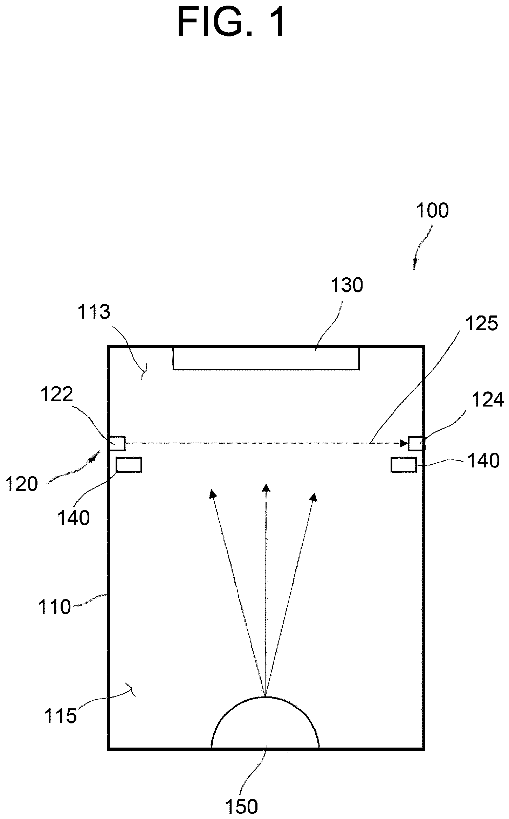

Fig. 1 is a drawing schematically illustrating a lithography device in accordance with one example embodiment of the present disclosure.

Hereinafter, embodiments of the present disclosure will be described in detail with reference to the accompanying drawings. The embodiments of the present disclosure are provided so that those skilled in the art with a more complete description of the present disclosure, and the following examples may be modified in various other forms, however, the scope of the present disclosure is not limited to the following embodiments. Rather, these embodiments are provided to make the present disclosure more faithful and complete and to fully introduce the spirit of the present disclosure to those skilled in the art.

In the drawings, for example, variations in the depicted shapes may be expected depending on manufacturing techniques and/or tolerances. Accordingly, the embodiments of the present disclosure should not be construed as being limited to the specific shape of regions disclosed in the present specification but should include, for example, changes in shapes resulting from manufacturing the same. The same reference numerals are assigned to similar parts throughout the specification. Furthermore, various elements and areas in the drawings are schematically drawn. Accordingly, the present disclosure is not limited by the relative size or spacing drawn in the accompanying drawings.

The present disclosure relates to a device for preventing various types of particles placed on one side of a barrier module, such as dusts or fine particles produced during a process, from transferring to an opposite side of the barrier module by using the barrier module configured with an electrical potential barrier rather than a physical barrier, and in particular, for preventing the movement of the particles like the dusts or the fine particles generated during the process from transferring to a substrate not by physical collisions with the barrier module but by the electrical potential barrier. In present disclosure, the physical barrier is a barrier that mainly blocks the movement of the particles by physical collision, meaning a barrier having an actual shape, while the electrical potential barrier means a barrier that blocks the movement of the particles by, for example, coulomb force, rather than physical collision. Herein, the barrier module can be various types of the electrical potential barrier capable of preventing a transfer of the particles while electrically dividing a certain area from another area. For example, the barrier module includes a plurality of electron beams spaced apart by a predetermined distance. To this end, the barrier module can be comprised of an electron beam generator and an electron beam receptor which receives electron beams generated at the electron beam generator.

The particle transfer blocking device as such may be used in various devices, and can be used in a vacuum processing device that performs depositing processes or etching processes. In addition, the particle transfer blocking device as such may be applied to a lithography device for preventing the particles such as the dusts or Sn particles located near the light source for lithography from transferring to the substrate, thereby making it possible to dispense with the use of a pellicle in an EUV lithography device. Hereinafter, the lithography device according to one example embodiment of the present disclosure will be described with reference to the drawings.

Fig. 1 is a drawing schematically illustrating a lithography device in accordance with one example embodiment of the present disclosure.

Referring to Fig. 1, a lithography device 100 in accordance with one example embodiment of the present disclosure includes a chamber 110, a barrier module 120 and a particle capturing module 140.

An accommodation part inside the chamber 110 is comprised of two parts 113 and 115. The inside of the chamber 110 may be maintained as a vacuum condition with a vacuum pump (not shown). The accommodation part of the chamber 110 is divided into a first region 115 and a second region 113 by the barrier module 120.

A light source for lithography 150 is placed in the first region 115 within the chamber 110, and a substrate 130 such as a semiconductor wafer is located in the second region 113. The light source for lithography 150 can be an EUV (Extreme Ultraviolet) light source, but is not limited thereto, and a different light source with a shorter wavelength than the EUV light can be used. A photomask (not shown) for lithography is formed on a surface of the substrate 130. Further, a pellicle may be formed on the photomask if necessary.

The barrier module 120 is prepared for preventing the particles in the first region 115 such as the dusts or the Sn particles from transferring to the second region 113, wherein the barrier module 120 is not the physical barrier but the electrical potential barrier. For example, as illustrated in Fig. 1, one or more electron beams 125 may be used as the barrier module 120, and the electron beams 125 may be generated by a one-dimensional charged particle generator. Herein, each of the plurality of electron beams 125 may be spaced apart with its adjacent electron beam(s) by a predetermined distance, to thereby divide the accommodation part of the chamber 110 into the first region 115 and the second region 113. The electron beams 125 are generated at an electron beam generator 122, irradiated into the chamber 110, and received by an electron beam receptor 124. The number, the predetermined distance, an arrangement, and an electron beam energy, etc. of the electron beams 125 may be determined with optimized values to prevent movement of particles. In addition, although Fig. 1 illustrates the plurality of electron beams 125 arranged on a same plane, the present disclosure is not limited thereto. As another example, each of the plurality of electron beams 125 may be located on each different plane or on two or more layers.

Since the first region 115 and the second region 113 are distinguished from each other due to the plurality of electron beams 125, the particles such as the dusts or the Sn particles existing in the first region 115 are prevented from transferring to the second region 113. When the particles such as the dusts or the Sn particles have a negative (-) charge, they are prevented from transferring to the second region 113, by the electrical potential barrier of the barrier module 120 comprised of the plurality of the electron beams 125. Further, even if the particles such as the dusts or the Sn particles are positively (+) charged or not charged, the particles become negatively charged by the electron beams 125 when they move near the barrier module 120 comprised of the plurality of electron beams 125, thereby preventing the particles from transferring to the second region 113 through the electron beams 125, by the electrical potential barrier of the barrier module 120.

The particle capturing module 140, installed within the chamber 110, captures the particles within the chamber 110. The particle capturing module 140 may be installed around the barrier module 120, and may be installed adjacent to the barrier module 120 within the first region 115 where the light source for lithography 150 is placed as shown in Fig. 1. However, the present disclosure is not limited thereto, and the particle capturing module 140 may be installed adjacent to the barrier module within the second region 113 where the substrate 130 is placed. In addition, the particle capturing module 140 may be installed in both the first region 115 and the second region 113. Herein, the particle capturing module 140 may be installed in the first area 115 as shown in Fig. 1 to capture particles within the first area 115, and may be installed in the second area 113 to capture some particles that have passed through the barrier module 120, thereby preventing the particles from transferring to the substrate 130.

The particle capturing module 140 may be an electrostatic trap. According to one example embodiment of the present disclosure, one side of the electrostatic trap may be grounded and a positive (+) voltage may be applied to the other side thereof to capture the particles charged with a negative (-) charge by a barrier module 120 comprised of the electron beams 125. Through this, the electrostatic trap can more easily capture the particles within the chamber 110. When the particle capturing module 140 is installed in this manner, the particles within the chamber 110 can be removed by the particle capturing module 140, thereby preventing the particles from transferring to the substrate 130 placed in the second region 113. In particular, when the particle capturing module 140 is installed in the second area 113, in case the particle capturing module 140 is an electrostatic trap to which a positive (+) voltage is applied, even if the particles charged with a negative (-) charge pass through the barrier module 120 comprised of the electron beams 125, the particles can be captured by the particle capturing module 140, thereby further completely preventing the particles from transferring to the substrate 130 placed in the second region 113.

That is, when the lithography device 100 is configured as including the barrier module 120 and the particle capturing module 140 in accordance with one example embodiment of the present disclosure, the particles such as the dusts or the Sn particles existing on the side where the light source of lithography 150 is placed are prevented from transferring to the substrate 130 by the electrical potential barrier rather than the physical barrier. Thus, the dusts are prevented from being attached to the substrate 130 during the lithography process. Accordingly, the pellicle is not required in the lithography device 100 according to one example embodiment of the present disclosure, so that a complicated process for manufacturing the pellicle can be omitted. In addition, since the barrier module 120 can be re-used, unlike the pellicle, the cost required for the lithography process is reduced.

In addition, as described above, it is obvious that the device for preventing the movement of the particles by using the electrical potential barrier can be applied not only to the lithography device, but also to devices using various types of vacuum processed chambers that perform depositing processes and etching processes during which it may be problematic if the particles are attached to a substrate. In addition, the particles in the present disclosure may include all types of particles such as dusts, various types of fine particles, particles generated during a process, etc.

According to one example embodiment of the present disclosure, by installing the potential barrier made of the electron beams and the electron capturing module between the light source for lithography and the substrate, the dusts existing on the side where the light source for lithography is placed or the fine particles generated during the process are prevented from transferring to the surface of the substrate, thereby allowing implementation of the lithography device without using the pellicle.

Although the embodiments of the present disclosure have been illustrated and described above, the present disclosure is not limited to the specific embodiments described above, and anyone with ordinary skill in the art to which the present disclosure pertains may make various modifications without departing from the spirit of the present disclosure claimed in the following claims, and such modifications are within the scope of the following claims.

## Claims

1. A particle transfer blocking device, comprising:
a vacuum chamber in which an accommodation part is formed;
a barrier module which is provided in the vacuum chamber and divides the accommodation part of the vacuum chamber into a first region and a second region; and
a particle capturing module which is provided in the vacuum chamber and captures particles within the vacuum chamber;
wherein the barrier module is not a physical barrier but an electrical potential barrier serving to prevent the particles located in the first region from transferring to the second region.

2. The particle transfer blocking device of Claim 1, wherein the particle capturing module is installed in at least one of the first region and the second region, wherein the first region and the second region are adjacent to the barrier module.

3. The particle transfer blocking device of Claim 1, wherein the particle capturing module is an electrostatic trap.

4. The particle transfer blocking device of any one of Claims 1 to 3, wherein the barrier module includes:
an electron beam generator installed on one side inside the chamber; and
an electron beam receptor installed on an opposite side, facing the one side, inside the chamber, wherein the electron beam receptor receives electron beam generated by the electron beam generator.

5. The particle transfer blocking device of any one of Claims 1 to 3, wherein the particles are at least one of dusts and fine particles which are produced during processes.

6. A lithography device, comprising:
a vacuum chamber in which an accommodation part is formed;
a barrier module which is provided in the vacuum chamber and divides the accommodation part of the vacuum chamber into a first region where a light source for lithography is located and a second region where a substrate is located; and
a particle capturing module which is provided in the vacuum chamber and captures particles within the vacuum chamber;
wherein the barrier module is not a physical barrier but an electrical potential barrier serving to prevent the particles located in the first region from transferring to the second region.

7. The lithography device of Claim 6, wherein the particle capturing module is installed within at least one of the first region and the second region, wherein the first region and the second region are adjacent to the barrier module.

8. The lithography device of Claim 6, wherein the particle capturing module is an electrostatic trap.

9. The lithography device of any one of Claims 6 to 8, wherein the barrier module includes:
an electron beam generator installed on one side inside the chamber; and
an electron beam receptor installed on an opposite side, facing the one side, inside the chamber, wherein the electron beam receptor receives electron beam generated by the electron beam generator.

10. The lithography device of any one of Claims 6 to 8, wherein the particles are at least one of dusts and fine particles which are produced during processes.

11. The lithography device of Claim 10, wherein the particles are the dusts and Sn particles.

12. The lithography device of any one of Claims 6 to 8, wherein a mask is formed at the substrate.

13. The lithography device of any one of Claims 6 to 8, wherein the light source for lithography is an EUV (Extreme Ultraviolet) light source.
